# EUROPEAN PATENT APPLICATION

(11) **EP 4 791 138 A1**
(43) Date of publication of application: **12.08.2026**
(21) Application number: 26157956.9
(22) Date of filing: 11.02.2026
(51) Int. Cl.: H05K 7/20

(54) **SMART PRE-COOLING SYSTEM INCORPORATING THERMAL BUFFER TANK**

(30) Priority: 11.02.2025 US 202563757051 P; 05.02.2026 US 202619530837
(71) Applicant: Vertiv Corporation, Westerville, OH 43082 (US)
(72) Inventor: BALINT, Takacs, Westerville, 43082 (US); VOIGT, Tyler W., Westerville, 43082 (US); ULRICH, Philip R., Westerville, 43082 (US)
(74) Representative: Cousens, Nico

(57) **Abstract**

A system and method for smart pre-cooling in a single-phase or two-phase cooling system maintains a thermal buffer tank in fluid communication with the primary and secondary fluid networks of the cooling system (as applicable) wherein a fluid thermal buffer may be stored to provide reserve cooling capacity. A controller of the cooling system receives weather data, e.g., ambient temperatures for one or more segments of an hour, day, week, or other predetermined duration. For each segment, based on forecasted ambient temperatures, the controller may direct the thermal buffer tank to charge or use reserve cooling capacity to minimize overall energy consumption. For example, when temperatures are lower the thermal buffer tank may charge additional cooling capacity, and when temperatures are higher the thermal buffer tank may deploy reserve cooling capacity to reduce the burden on other chiller devices in removing heat from the system.

## Description

The present application claims the benefit under 35 U.S.C. § 119(e) of U.S. Provisional Patent Application Serial Number 63/757,051 filed February 11, 2025.

### TECHNICAL FIELD

The present disclosure is directed generally to the field of cooling systems for data centers and similar controlled-temperature environments, and more particularly, to monitoring of two-phase pumping systems within a cooling system.

### BACKGROUND

Data center environments incorporate multiple systems in addition to the servers and other information technology (IT) equipment operating therein. For example, the IT equipment is housed in racks. Power distribution units (PDU) deliver operating power to the IT devices and monitor power usage. Coolant distribution units (CDU) circulate air-cooled or liquid-cooled refrigerant through the IT equipment to absorb heat generated by the processors thereof. Chiller devices transfer and dissipate heat from the CDUs, generally to an exterior ambient environment, and resupply the CDUs with a cooled medium.

Broadly speaking, the higher the ambient air temperature outside the data center environment, the less efficiently a given level of cooling capacity, e.g., the capacity required to maintain the data center environment and/or the IT devices therein within a required temperature range, can be provided. For example, freecooling units or air-cooled chiller devices responsible for dissipating transferred heat into the outside air must expend more energy with respect to condenser fans (due to higher speeds) and compressors (due to increased condensing pressure). Similarly, some cooling technologies operate more efficiently at lower ambient temperatures, e.g., the aforementioned freecooling units or pump refrigerant economizers. Conventional cooling systems, however, are not fine-tuned for optimal energy consumption based on ambient temperature changes throughout the day.

### SUMMARY

In a first aspect, a cooling system incorporating smart pre-cooling via thermal buffer tanks is disclosed. In embodiments, the cooling system may include one or more cooling devices for transferring heat from one or more downstream servers, switches, or other information technology (IT) devices by circulating a fluid coolant through the IT devices. The cooling system may include a thermal buffer tank fluidly coupled to the cooling device and to the downstream IT devices. For example, the thermal buffer tank may maintain a fluid thermal buffer, which may be similar to or different from the fluid coolant. The cooling system may include a controller with at least one control processor. For example, the controller may receive cooling requirements associated with maintaining the downstream IT devices within an acceptable temperature range. The controller may further receive a weather forecast for a duration including two or more segments (e.g., weekly, monthly), wherein the forecast includes weather forecast data for each segment (e.g., daily, weekly). Based on the weather data forecasted for the first segment, the controller may select a buffer tank operation for the first segment: charging the buffer tank with fluid thermal buffer via the cooling device, or transferring heat from the IT devices via the fluid thermal buffer previously stored to the thermal buffer tank.

In some embodiments, the controller may signal the thermal buffer tank to execute the selected thermal buffer tank operation.

In some embodiments, the weather forecast data includes an ambient temperature, and the controller may compare the ambient temperature with low and/or high temperature thresholds.

In some embodiments, when the ambient temperature is not more than the low threshold, the selected buffer tank operation may include charging the thermal buffer tank.

In some embodiments, when the ambient temperature is not less than the high threshold, the selected buffer tank operation may include transferring heat from the downstream IT devices via fluid thermal buffer from the thermal buffer tank.

In some embodiments, when the ambient temperature is between the low and high thresholds, the controller may not execute a buffer tank operation for that segment.

In some embodiments, the selection of the buffer tank operation may additionally be based on the cooling requirements of the downstream IT devices and/or the capacity of the thermal buffer tank/s.

In some embodiments, the controller may select the buffer tank operation to minimize energy consumption by the cooling device/s.

In some embodiments, the cooling system may be a two-phase cooling system including a primary or first-phase cooling device fluidly coupled to a second-phase cooling device, e.g., a coolant distribution unit (CDU), via a primary fluid network, and wherein the second-phase CDU includes heat exchangers for transferring heat between a secondary fluid network and the primary fluid network, the secondary fluid network circulating a fluid coolant through the downstream IT devices to transfer heat therefrom. For example, the primary fluid network may receive the transferred heat from the IT devices via the heat exchangers, and the first-phase cooling device may then remove that heat from the cooling system. The thermal buffer tank may be connected to both first-phase and second-phase cooling devices.

In some embodiments, the first-phase cooling device may be a dry cooler or air-cooled chiller device.

In a further aspect, a method for cooling an environment of servers, switches, and/or other IT devices is disclosed. In embodiments, the method may include providing a cooling system comprising one or more cooling devices for transferring heat generated by the IT devices by circulating a fluid coolant through the IT devices. The method may include receiving cooling requirements based on maintaining the IT devices within an acceptable temperature range via a controller of the cooling system. The method may include providing a thermal buffer tank fluidly connected to the cooling device/s and the IT devices, the thermal buffer tank capable of maintaining a fluid thermal buffer. The method may include receiving, via the controller, a weather forecast for a duration including multiple segments (e.g., a day, a week, a month), the forecast including weather data forecast for each segment (e.g., hourly, daily, weekly). The method may include selecting, via the controller, a buffer tank operation for at least one segment of the duration based at least on the weather data forecast for that segment. For example, the buffer tank operation may include charging the buffer tank, e.g., with fluid thermal buffer at a particular temperature, via the cooling device/s. Alternatively, the buffer tank operation may include transferring heat from the IT devices by circulating the fluid thermal buffer within the thermal buffer tank through the IT devices.

In some embodiments, the method may include receiving ambient temperature forecast data for each segment of the duration.

In some embodiments, the method may include determining that the ambient temperature for a given segment is equal to or less than a low temperature threshold, and accordingly selecting to charge the buffer tank.

In some embodiments, the method may include determining that the ambient temperature for a given segment is equal to or greater than a high temperature threshold, and accordingly selecting to circulate the fluid thermal buffer in the thermal buffer tank through the IT devices to transfer heat.

In some embodiments, the method may include determining that the ambient temperature for a given segment is between the low and high thresholds, and accordingly selecting to take no further action for that segment via the thermal buffer tank.

In some embodiments, the method may include selecting the buffer tank operation based additionally on the cooling requirements of the downstream IT devices and/or the capacity of the thermal buffer tank.

In some embodiments, the method may include selecting the buffer tank operation based on minimizing energy consumption by the cooling device/s.

In some embodiments, the method may include providing a two-phase cooling system comprising a first-phase cooling device fluidly coupled to a second-phase cooling device (e.g., a coolant distribution unit (CDU)) for circulating the fluid coolant through the IT devices via a secondary fluid network) by a primary fluid network. For example, the second-phase CDU may include heat exchangers for transferring heat from the secondary fluid network to the primary fluid network, so the first-phase cooling device can remove the transferred heat from the system and/or environment.

In some embodiments, the method may include providing a dry cooler or air-cooled chiller device as the first-phase cooling device.

In some embodiments, the method may additionally include signaling the thermal buffer tank, via the controller, to direct the thermal buffer tank to execute the selected buffer tank operation.

This Summary is provided solely as an introduction to subject matter that is fully described in the Detailed Description and Drawings. The Summary should not be considered to describe essential features nor be used to determine the scope of the Claims. Moreover, it is to be understood that both the foregoing Summary and the following Detailed Description are example and explanatory only and are not necessarily restrictive of the subject matter claimed.

### BRIEF DESCRIPTION OF THE FIGURES

The detailed description is described with reference to the accompanying figures. The use of the same reference numbers in different instances in the description and the figures may indicate similar or identical items. Various embodiments or examples ("examples") of the present disclosure are disclosed in the following detailed description and the accompanying drawings. The drawings are not necessarily to scale. In general, operations of disclosed processes may be performed in an arbitrary order, unless otherwise provided in the claims. In the drawings:
FIG. 1 is a block diagram of a pumped two-phase cooling system incorporating smart pre-cooling via a thermal buffer tank according to example embodiments of the inventive concepts disclosed herein;
FIG. 2A is a block diagram of a buffer tank configuration of the cooling system of FIG. 1;
FIGS. 2B and 2C are respectively block diagrams of buffer tank charging and buffer tank usage operations of the cooling system of FIG. 1;
FIG. 2D is a block diagram of a single-phase cooling system incorporating smart pre-cooling via a thermal buffer tank as disclosed with respect to the cooling system of FIG. 1;
FIG. 3 is a diagrammatic illustration of smart pre-cooling operations based on a periodic weather forecast according to the cooling system of FIGS. 1 and 2D;
FIG. 4 is a diagrammatic illustration of an operational flow of the smart pre-cooling operations of FIG. 3;and
FIGS. 5A and 5B are process flow diagrams illustrating a method for thermal management incorporating smart pre-cooling for a single-phase or two-phase cooling system according to example embodiments of the inventive concepts disclosed herein.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "some embodiments" means that a particular element, feature, structure, or characteristic described in connection with the embodiment is included in at least one embodiment disclosed herein. The appearances of the phrase "in some embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly speaking, embodiments of the inventive concepts disclosed herein are directed to methods and systems for thermal management within a data center environment incorporating smart pre-cooling by modifying the usage of thermal buffer tanks. For example, thermal buffer tanks may be used to ensure reserve cooling capacity in the event of significant heat load fluctuations, e.g., associated with spikes or surges in operating power characteristic of generative artificial intelligence (AI) or other similar high-performance computing (HPC) loads. Embodiments of a smart pre-cooling system may use the thermal buffer tanks to create additional cooling capacity when it is most efficient to do so, based on detailed weather forecasting. This additional cooling capacity may be deployed in conjunction with, or in place of, conventional chiller devices and/or pumped units when higher ambient temperatures render these devices and units less efficient to use. As a result, overall energy consumption throughout the cooling system may be minimized to any desired level of precision.

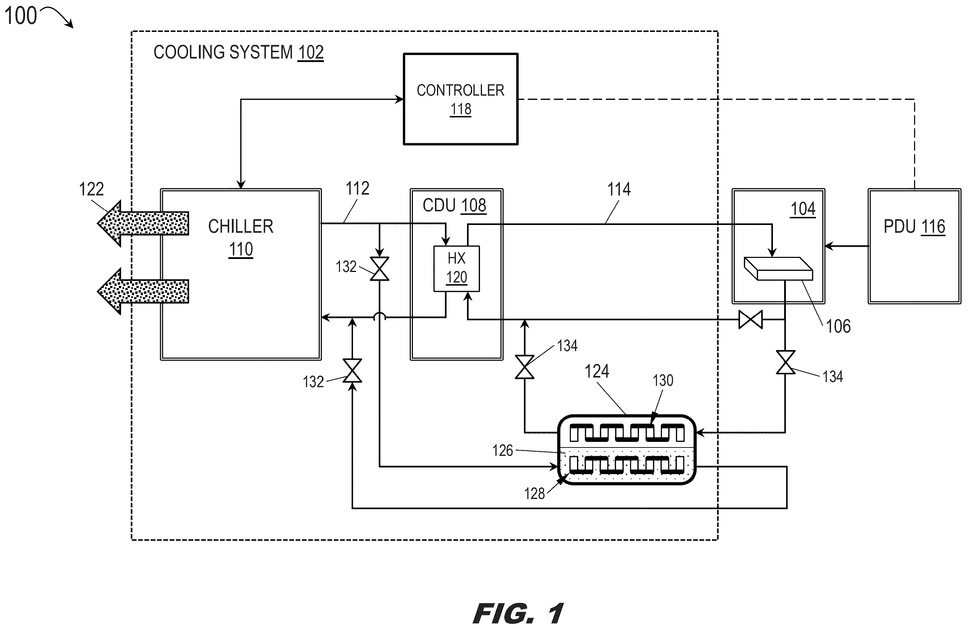

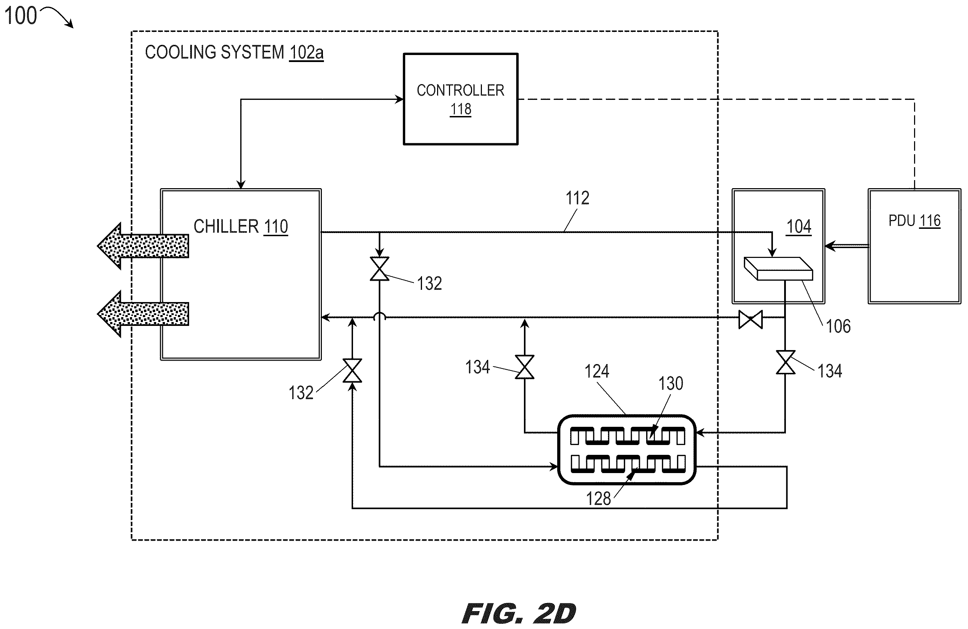

Referring now to FIG. 1, a data center environment 100 served by a cooling system 102 is shown. The data center environment 100 may include racks 104 of IT devices 106 (e.g., servers, switches, and other like processing devices). The cooling system 102 may include coolant distribution units (CDU) 108 (e.g., pumping units), chiller devices 110, primary fluid network 112, secondary fluid network 114, power distribution unit/s 116 (PDU), and supervisory controller 118. In embodiments, the cooling system 102 may be a pumped two-phase cooling system, as shown by FIG. 1, or a single-phase cooling system, as shown below by FIG. 2D.

In embodiments, IT devices 106 are housed in racks 104 or rows within the environment 100. For example, each IT device 106 may be provided with operating power by a PDU 116 into which the IT device is plugged or otherwise connected, e.g., directly or indirectly via a rack 104 or shelf in which the IT device is housed or otherwise disposed.

In embodiments, the CDU 108 may connect the primary fluid network 112 and secondary fluid network 114, e.g., via heat exchanger 120 (HX). For example, the CDU 108 may circulate a fluid coolant through the secondary fluid network 114 such that the fluid coolant leaves the pumping units at a particular outlet temperature and at a particular flow rate. When the fluid coolant reaches the IT devices 106, heat generated by the IT devices (based on the operating power provided by the PDU 116) is transferred to the fluid coolant and returned to the CDU 108 via the secondary fluid network 114, e.g., at a return temperature higher than the outlet temperature due to the absorbed heat.

In some embodiments, the cooling system 102 may be a direct-to-chip (D2C) cooling system wherein the secondary fluid network 114 directs fluid coolant or fluid refrigerant into thermal communication with chip assemblies. For example, chip assemblies may include cold plates (not shown) in direct thermal contact with chips and/or processors of the IT devices 106, such that thermal energy generated by the chips/processors may be directly transferred through the cold plates to the secondary fluid network 114 and thereby returned to the CDU 108.

In embodiments, heat transferred from the IT devices 106 may further be transferred to the primary fluid network 112 via heat exchangers 120 within the CDU 108. For example, the chiller devices 110 may likewise circulate through the primary fluid network 112 a fluid coolant (e.g., water, water/glycol, or a different fluid coolant or refrigerant than is circulated through the secondary fluid network 114) that leaves the chiller devices at a particular outlet temperature and/or flow rate. In embodiments, the heat exchangers 120 within the CDU 108 may transfer absorbed heat from the secondary fluid network 114 to the primary fluid network 112, which returns this transferred heat to the chiller devices 110. Similarly to the secondary fluid network 114, fluid coolant circulating through the primary fluid network 112 may return to the chiller devices 110 at a return temperature higher than the outlet temperature. In embodiments, the chiller devices 110 may dissipate absorbed heat from the primary fluid network 112 to external outlets, e.g., directing the absorbed heat into the air outside the environment 100 via fans and air ducts. In this way, the cooling system 102 removes (122) heat from the environment 100 such that conditions within the environment are maintained within predetermined acceptable ranges, e.g., for air temperature and/or humidity. For example, if air temperatures within the environment 100 are allowed to exceed acceptable ranges, processing operations of the IT devices may be impeded or throttled.

In embodiments, the cooling system 102 may include a thermal buffer tank 124. For example, the thermal buffer tank 124 may maintain a capacity or quantity of fluid thermal buffer 126, e.g., water as circulated through the primary fluid network 112, fluid coolant as circulated through the secondary fluid network 114, or a mixture thereof. At any given time, the thermal buffer tank 124 may represent a particular cooling capacity, based on, e.g., the quantity of fluid thermal buffer 126 present and its current temperature, available to supplement the cooling capacity of the chiller devices 110 and/or CDU 108.

In embodiments, the thermal buffer tank 124 may include cold-side heat exchangers 128, e.g., on a "cold side" where the thermal buffer tank is connected to the primary fluid network 112. Similarly, the thermal buffer tank 124 may include hot-side heat exchangers 130, e.g., on a "hot side" where the thermal buffer tank is connected to the secondary fluid network 114.

In embodiments, the thermal buffer tank 124 may be connected to the primary fluid network 112 via primary valves 132 and to the secondary fluid network 114 via secondary valves 134.

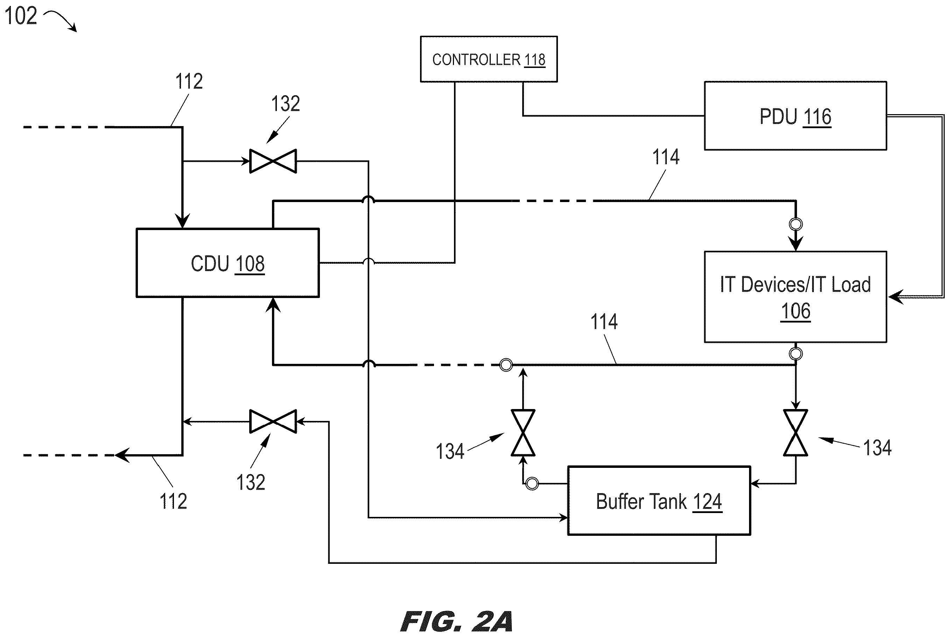

### FIGS. 2A through 2D - CHARGE AND USE OPERATIONS

Referring generally to FIGS. 2A through 2C, the cooling system 102 is shown. In particular, the IT devices 106, CDU 108, primary fluid network 112, secondary fluid network 114, PDU 116, thermal buffer tank 124, cold-side heat exchangers 128, hot-side heat exchangers 130, primary valves 132, and secondary valves 134 are shown.

In embodiments, the thermal buffer tank 124 may be closed off and/or disconnected from the primary fluid network 112 and secondary fluid network 114 via the primary valves 132 and secondary valves 134 respectively. For example, the thermal buffer tank 124 may be closed off on both its hot and cold sides, e.g., for storage of fluid thermal buffer 126 (FIG. 1), e.g., a predetermined volume at a predetermined temperature, representing a particular level of reserve cooling capacity.

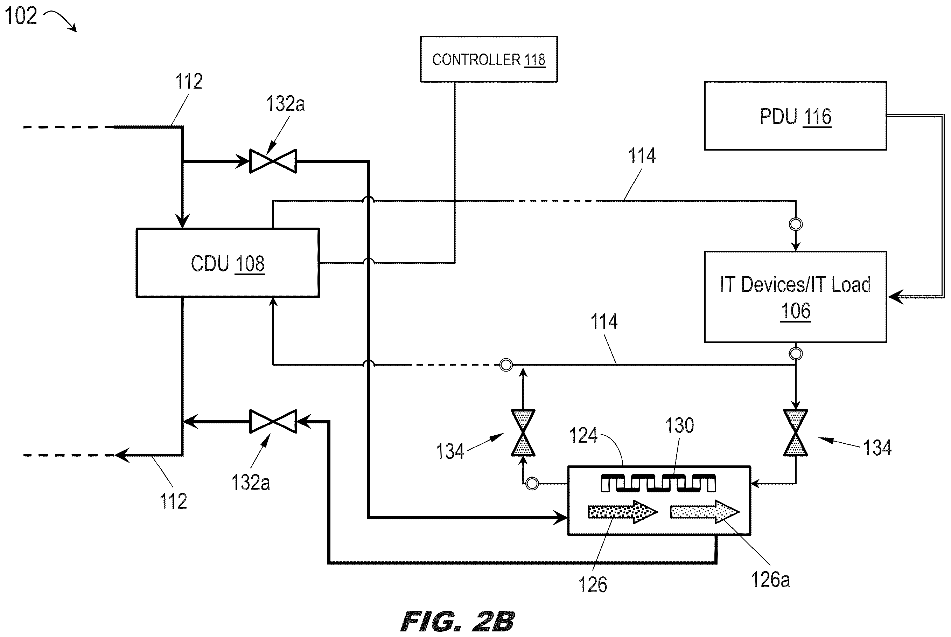

Referring in particular to FIG. 2B, in embodiments the thermal buffer tank 124 may be charged, e.g., via the chiller device 110. For example, by opening the primary valves 132a and closing the secondary valves 134, the thermal buffer tank 124 may be opened on its cold side and fluidly connected to the primary fluid network 112. Further, the fluid thermal buffer 126 (pre-cooled by the chiller devices 110, FIG. 1) may be circulated through the primary fluid network 112, and hot-side heat exchangers 130 activated to transfer heat from the fluid thermal buffer 126 to the primary fluid network for removal from the thermal buffer tank 124, cooling the fluid thermal buffer (126a) to a desired temperature for future use. As noted above, the thermal buffer tank 124 may represent a reserve cooling capacity defined by the level or volume of fluid thermal buffer 126 therein and its temperature.

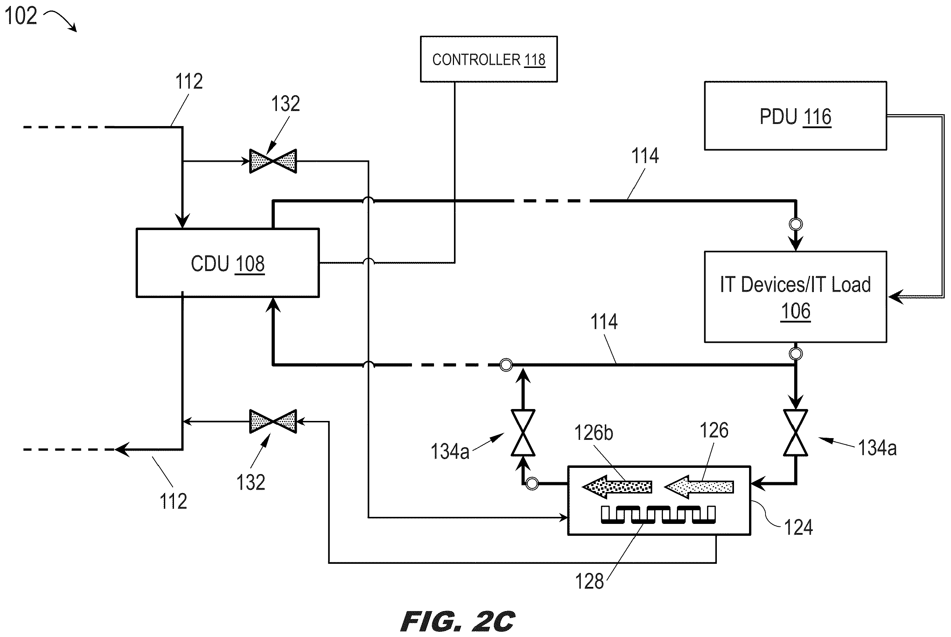

Referring in particular to FIG. 2C, in embodiments the thermal buffer tank 124 may be used to supplement the cooling capacity of the chiller device 110 and/or CDU 108. For example, by opening the secondary valves 134a and closing the primary valves 132, the thermal buffer tank 124 may be opened on its hot side and fluidly connected to the secondary fluid network 114. In embodiments, cold-side heat exchangers 128 within the thermal buffer tank 124 may transfer heat (126b) from the fluid coolant 126 returning from the IT devices 106 (and carrying heat transferred therefrom) to the CDU 108, where the transferred heat would otherwise be transferred from the secondary fluid network 114 to the primary fluid network 112 for removal by the chiller device 110. For example, reserve cooling capacity within the thermal buffer tank 124, e.g., a volume of fluid thermal buffer 126 at a reserve temperature, may be utilized during warmer periods of the day to reduce the burden on the CDU 108 and/or chiller devices 110 to remove heat from the environment 100 (see FIG. 1).

Referring now to FIG. 2D, the cooling system 102a may be implemented and may function similarly to the cooling system 102 of FIGS. 1 through 2D, except that the cooling system 102a may be a single-phase cooling system. For example, the cooling system 102a may incorporate only a single or first-phase cooling device (e.g., chiller device 110) and a single or first-phase fluid network (e.g., primary fluid network 112), via which the thermal buffer tank 124 may be charged or used as disclosed above, e.g., in conjunction with primary valves 132 and secondary valves 134.

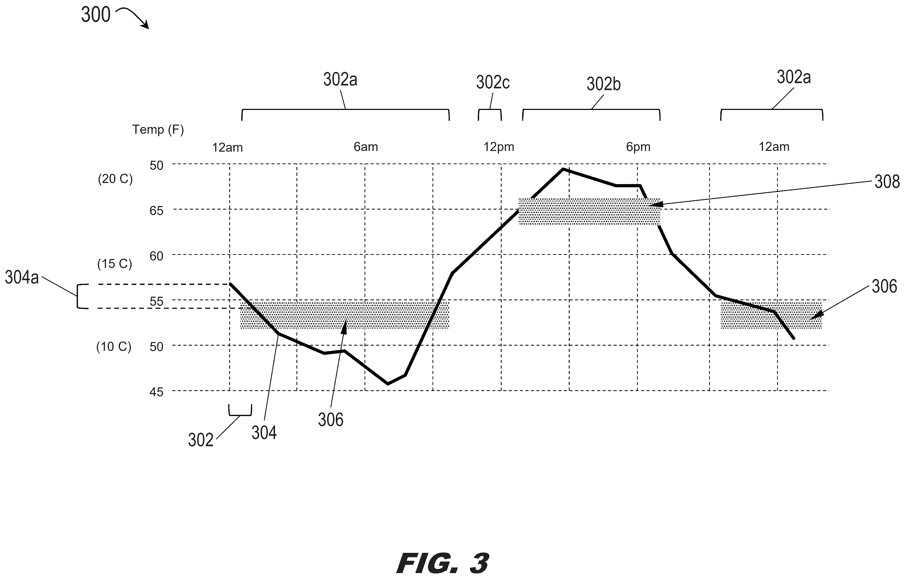

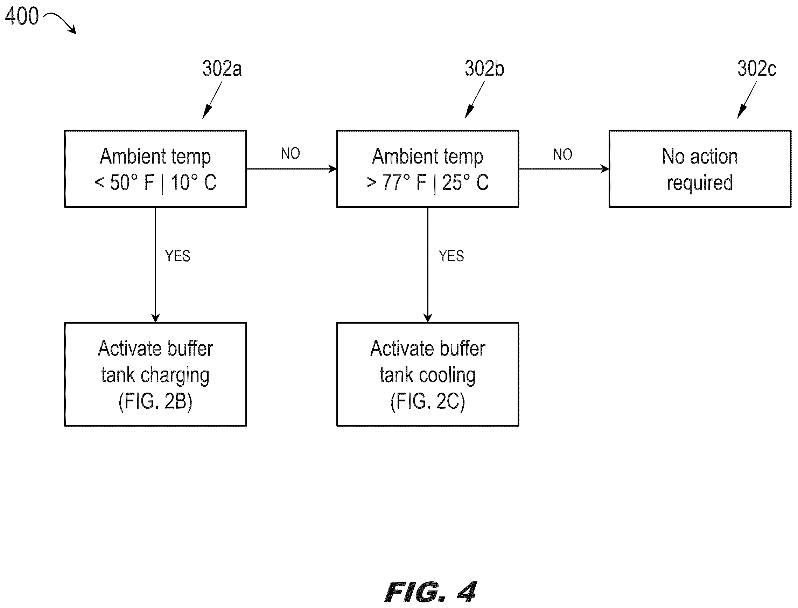

### FIG. 3 and 4- WEATHER DATA/THRESHOLD BASED MANAGEMENT

Referring to FIGS. 3 and 4, a weather forecast 300 may be provided to the supervisory controller 118 (see FIG. 1) and a process 400 for smart pre-cooling implemented by the supervisory controller based on the weather forecast. In embodiments, the weather forecast 300 may comprise forecasted ambient air temperatures for a fixed future duration, e.g., the next 24 hours, the next week. Further, the weather forecast 300 may forecast or estimate ambient temperatures for each of a sequence of segments, divisions, or sub-durations of the future duration (which may be equal or unequal in length). For example, the weather forecast 300 may provide, for each hour 302 of a 24-hour day, a forecasted ambient temperature 304 or a forecasted ambient temperature range 304a, within which the ambient air temperature is expected to occur during that hour.

In embodiments, the supervisory controller 118 may use the weather forecast 300 to direct charging and usage operations of the thermal buffer tank 124 (see FIG. 1), as shown by FIGS. 2B through 2D, at times throughout the duration when it is most advantageous to do so with respect to overall energy conservation. For example, during hours 302a (segments) when the forecasted ambient temperature 304 (or ambient temperature range) is at or below a low temperature threshold 306, the supervisory controller 118 may direct engagement of the appropriate primary and secondary valves 132a, 134 (see FIG. 2B) and charging of the thermal buffer tank 124, e.g., via the chiller devices 110 and primary fluid network 112 (see FIG. 2A), when lower ambient temperatures enable more efficient cooling (126a) of the fluid thermal buffer 126.

Similarly, during hours 302b when forecasted ambient temperatures 304 are at or above a high temperature threshold 308, the supervisory controller 118 may direct engagement of the primary and secondary valves 132, 134a to provide alternative thermal management (126b) of the IT devices 106 via the thermal buffer tank 124 (as shown by FIG. 2C) instead of the CDU 108. For example, due to higher ambient temperatures 304, the CDU 108 would otherwise expend higher amounts of energy to maintain the IT devices 106 within the required temperature range as opposed to hours 302a when ambient temperatures are lower.

Referring also to FIG. 4, during hours 302c when ambient temperatures 304 are between the low temperature and high temperature thresholds 306, 308 (e.g., neither too low nor too high), the supervisory controller 118 may take no special action and allow the cooling system 102 to operate nominally. In some embodiments, the supervisory controller 118 may provide that no additional action be taken based on the current capacity of the thermal buffer tank 124, e.g., if the tank is full and no additional cooling capacity can be added, if the tank is empty and no additional cooling capacity can be deployed.

In embodiments, the process 400 may be implemented to any degree of precision provided for by the weather forecast 300, e.g., for each hour 302 of a day, for each day of a week, for each minute of an hour, for segments of any size throughout the day provided the weather forecast provides correlated ambient temperature data 304 correlated with said segment. In some embodiments, weather forecasts 300 may incorporate historical weather data.

In embodiments, the process 400 may include optimizing smart pre-cooling via the thermal buffer tank 124 and may be initiated every hour (or at appropriate intervals throughout the day), based on current weather forecasts 300 and/or weather data incorporated therein. However, the supervisory controller 118 (or other like processor) may generate mathematical models of one or more components of the cooling system 102, e.g., the CDU 108, chiller devices 110, and/or thermal buffer tank 124 (see FIG. 1), as well as the weather forecast 300 (see FIG. 3).

In embodiments, with respect to each hour 302 or other segment of the duration addressed by the weather forecast 300, the thermal buffer tank 124 may be either charged or used, as shown by FIGS. 2B and 2C respectively. Further, the thermal buffer tank 124 may be associated with a maximum cooling capacity (based on the volume and temperature of fluid thermal buffer 126 contained therein) that may be augmented by charging or depleted by usage, such that the cooling capacity of the thermal buffer tank may also be time-limited. Further still, any required temperature, humidity, and/or environmental conditions must be maintained on a continual and uninterrupted basis with respect to the environment 100 and/or IT devices 106 within.

In embodiments, given the above parameters, the supervisory controller 118 may optimize cooling operations throughout the day (or other applicable duration) to minimize overall energy consumption with respect to the cooling system 102 and individual components thereof, e.g., CDU 108, chiller devices 110, and/or thermal buffer tank 124. For example, during cooler parts of the day, the supervisory controller 118 may prioritize charging and/or cooling (126a) of the fluid thermal buffer 126 (e.g., via the chiller devices 110 and primary fluid network 112, as shown by FIG. 2B) to build capacity within the thermal buffer tank 124 when it is most efficient to do so. Similarly, during warmer parts of the day, the supervisory controller 118 may direct usage of the thermal buffer tank 124 to reduce dependency on the CDU 108, providing heat transfer (126b) from the IT devices 106 via the fluid thermal buffer 126 instead of the secondary fluid network 114 (e.g., as shown by FIG. 2C).

By way of a non-limiting example, the optimization problem may be formulated as follows: ${ArgMin}_{tank _ {usage}_{i}} {\sum }_{i = 1}^{24 ∗ segments} {E}_{{C}_{i}} + {E}_{{T}_{i}}$ where, for each segment i:
*E_{Cᵢ} = f* (*Ambientᵢ, Coolingᵢ, tank_usageᵢ*)
*E_{rᵢ} = f* (*Ambientᵢ, Coolingᵢ, tank_usageᵢ*)
*tank_usageᵢ* ∈(*chargeₘₐₓ*, *useₘₐₓ*)
*tank_capacityᵢ* ∈ (0, *capacityₘₐₓ*
*Cooling_{required}* = *f* (*Coolingᵢ, Tankᵢ*)
*segments* ∈ (0,60)

In embodiments, ***E***_{C} may represent the energy required to maintain the required cooling capacity (e.g., for uninterrupted maintenance of the environment 100 within required temperature ranges, based on forecasted ambient temperatures) and ***E**_{T}* may represent the energy provided by the current cooling capacity of the thermal buffer tank 124. Further, ***i*** may represent the relevant segment or sub-duration, chosen as broadly or precisely as desired (e.g., each hour of a 24-hour day, each minute of a 60-minute hour, each minute of a 24 x 60 = 1,440-minute day). For example, a given hour or day may include segments ***i*** of various durations, larger or smaller depending on the desired degree of precision. As noted above, the amount of cooling capacity storable or reservable by the thermal buffer tank 124, and the amount of reserve cooling capacity deployable or usable therefrom, is limited by the physical volume of the tank.

In embodiments, the solution *E_{Cᵢ} + E_{Tᵢ}* to the above optimization problem may represent the cooling capacity of the thermal buffer tank 124 to be used for that segment ***i*** (e.g., a positive capacity representing usage from the thermal buffer tank, a negative capacity representing charging the thermal buffer tank to build capacity). In some embodiments, the cooling requirements referenced above may be fixed, manually updated, or may self-update, e.g., "learning" from accumulated historical data.

In embodiments, when a solution is reached for the current segment ***i***, the supervisory controller 118 may signal the appropriate components of the cooling system 102 (e.g., the CDU 108, chiller device 110, or thermal buffer tank 124) to implement the solution (charge buffer tank, use buffer capacity, take no action/normal operations) and operate the appropriate primary or secondary valves 132, 134.

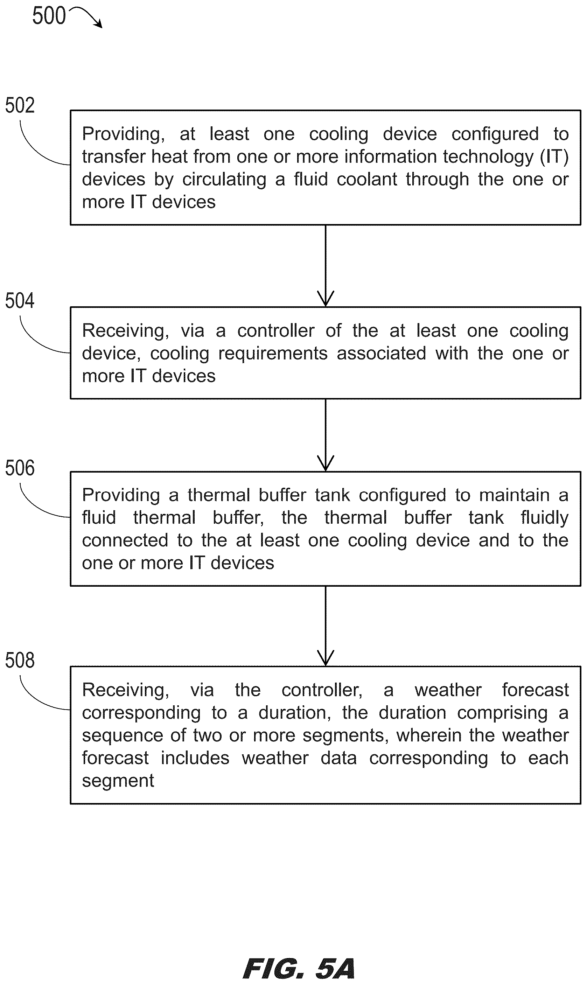

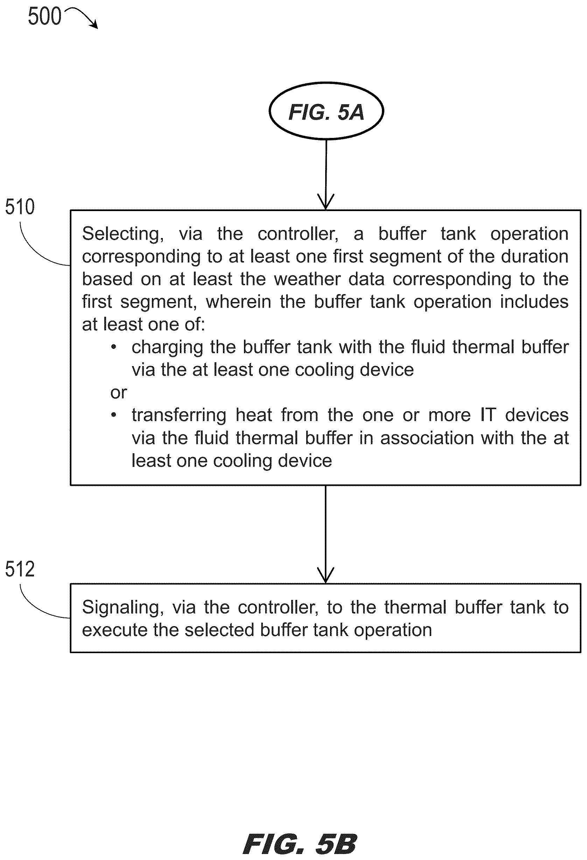

### FIGS. 5A and 5B - METHOD

Referring now to FIG. 5A, the method 500 may be implemented by the cooling system 102 and/or the supervisory controller 118 thereof, and may include the following steps.

At step 502, cooling devices are provided for transferring heat from servers, switches, and/or other IT devices within a data center environment. In some embodiments, the cooling devices includes air-cooled chiller or freecooling devices, or coolant pumping units/coolant distribution units (CDU). In some embodiments, the cooling devices are part of a direct-to-chip (D2C) system in direct thermal communication with chips or processors within the IT devices. In some embodiments, the cooling devices are mathematically modeled. In some embodiments, the cooling system is a single-phase cooling system incorporating a single, rather than two-phase, fluid network.

At step 504, a controller of the cooling system (and/or cooling devices thereof) receives cooling requirements for the environment, IT devices, and/or chip assemblies. For example, cooling requirements may include required temperature ranges within which the environment, devices, and/or chip assemblies must be maintained on an uninterrupted basis.

At step 506, a thermal buffer tank is provided. For example, the thermal buffer tank maintains a quantity of fluid thermal buffer (with a total cooling capacity based on the volume, properties, and temperature of the fluid buffer) and is fluidly connected to the cooling devices. For example, the cooling devices may be connected to the IT devices via primary and secondary fluid networks according to a two-phase pumped system, with the thermal buffer tank connected to the primary and secondary fluid networks via primary and secondary valves. In some embodiments, the thermal buffer tank is mathematically modeled, e.g., according to a desired cooling capacity.

At step 508, the controller receives a weather forecast for a particular duration (e.g., a week or day) comprising a sequence of segments (e.g., days of the week, hours the day, other sub-durations of uniform or varied length as desired) wherein weather data is provided for each segment. For example, the weather forecast may track predicted and/or historical ambient temperatures for each hour of the day, each two-hour window of the day, etc.

Referring also to FIG. 5B, at step 510, the controller selects a buffer tank operation for a segment, or for each segment, of the duration corresponding to the weather forecast. For example, based on ambient temperature data for each segment, the controller may charge the thermal buffer tank, via the cooling devices (e.g., when ambient temperatures are at or below a low temperature threshold), transfer heat from the IT devices by using the current cooling capacity of the thermal buffer tank (e.g., when ambient temperatures are at or above a high temperature threshold, and energy may be conserved as opposed to using CDUs/pumping units), or take no action and allow the cooling system to operate normally (e.g., when ambient temperatures are between a low and high threshold, or when the thermal buffer tank is unable to charge or deploy additional cooling capacity). In some embodiments, the controller may optimize directions for each segment by selecting the buffer tank operation minimizing total energy usage throughout the cooling system for that segment, based on cooling requirements and/or the current available cooling capacity of the thermal buffer tank.

The method 500 may include an additional step 512. At step 512, the controller signals the thermal buffer tank and/or cooling devices to implement the selected buffer tank operation.

### CONCLUSION

Embodiment of the inventive concepts disclosed herein may provide for more efficient thermal management by optimizing energy conservation on a dynamic and proactive basis by deploying the thermal buffer tank to optimal effect based on the expected temperature and weather conditions throughout the day (e.g., charging the thermal buffer during significantly colder portions of the day, and using the charged thermal buffer for supplemental thermal management during warmer portions of the day). Broadly speaking, observations of the disclosed system show a correlation of greater thermal buffer tank capacity with increased energy conservation.

The apparatuses and methods described in this application may be partially or fully implemented by a special-purpose computer created by configuring a general-purpose computer to execute one or more particular functions embodied in computer programs. The functional blocks, flowchart components, and other elements described above serve as software specifications, which can be translated into computer programs by the routine work of a skilled technician or programmer.

The computer programs include processor-executable instructions that are stored on at least one non-transitory, tangible computer-readable medium. The computer programs may also include or rely on stored data. The computer programs may encompass a basic input/output system (BIOS) that interacts with the hardware of the special-purpose computer, device drivers that interact with particular devices of the special-purpose computer, one or more operating systems, user applications, background services, background applications, etc.

The computer programs may include: (i) descriptive text to be parsed, such as HTML (hypertext markup language), XML (extensible markup language), or JSON (JavaScript Object Notation) (ii) assembly code, (iii) object code generated from source code by a compiler, (iv) source code for execution by an interpreter, (v) source code for compilation and execution by a just-in-time compiler, etc. As examples only, source code may be written using syntax from languages including C, C++, C#, Objective-C, Swift, Haskell, Go, SQL, R, Lisp, Java^{®}, Fortran, Peri, Pascal, Curl, OCaml, Javascript^{®}, HTML5 (Hypertext Markup Language 5th revision), Ada, ASP (Active Server Pages), PHP (PHP: Hypertext Preprocessor), Scala, Eiffel, Smalltalk, Erlang, Ruby, Flash^{®}, Visual Basic^{®}, Lua, MATLAB, SIMULINK, and Python^{®}.

Process flowcharts discussed herein illustrate the operation of possible implementations of systems, methods, and computer program products according to various embodiments of the present disclosure. In this regard, each block in the flowchart may represent a module, segment, or portion of code, which comprises one or more executable instructions for implementing the specified logical function(s). It should also be noted that, in some alternative implementations, the functions noted in the blocks might occur out of the order depicted in the figures. For example, blocks shown in succession may be executed substantially concurrently. It will also be noted that each block of flowchart illustration can be implemented by special-purpose hardware-based systems that perform the specified functions or acts, or combinations of special-purpose hardware and computer instructions.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not intended to be exhaustive or to limit the embodiments to the precise forms disclosed. It will be apparent to one of ordinary skill in the art that many modifications and variations are possible in view of the above teachings.

## Claims

1. A cooling system (102), comprising:
at least one cooling device (110) configured to transfer heat from one or more information technology "IT" devices (106) by circulating a fluid coolant through the one or more IT devices;
a thermal buffer tank (124) capable of maintaining a fluid thermal buffer (126), the thermal buffer tank fluidly coupled to the at least one cooling device and to the one or more IT devices;
and
a controller (108) including at least one processor, the controller configured to:
receive cooling requirements associated with the one or more IT devices;
receive a weather forecast corresponding to a duration, the duration comprising a sequence of two or more segments, wherein the weather forecast includes weather data corresponding to each segment;
and
select a buffer tank operation corresponding to at least one first segment of the duration based at least on the weather data corresponding to the first segment, wherein the buffer tank operation includes at least one of:
charging the buffer tank with the fluid thermal buffer via the at least one cooling device;
or
transferring heat from the one or more IT devices via the fluid thermal buffer in association with the at least one cooling device.

2. The cooling system of Claim 1, wherein the controller is further configured to signal the thermal buffer tank to execute the selected buffer tank operation.

3. The cooling system of Claim 1 or 2, wherein:
the weather data includes an ambient temperature;
and
wherein the controller is configured to compare the ambient temperature with one or more of a low temperature threshold or a high temperature threshold.

4. The cooling system of Claim 3, wherein the buffer tank operation includes charging the buffer tank upon determining that the ambient temperature is not more than the low temperature threshold.

5. The cooling system of Claim 3 or 4, wherein the buffer tank operation includes transferring heat from the one or more IT devices via the fluid thermal buffer upon determining that the ambient temperature is not less than the high temperature threshold.

6. The cooling system of any of Claims 3 to 5, wherein the buffer tank operation includes taking no additional action with respect to the thermal buffer tank upon determining that the ambient temperature is between the low temperature threshold and the high temperature threshold.

7. The cooling system of any preceding Claim, wherein the controller is configured to select the buffer tank operation based on the weather data and at least one of:
the cooling requirements associated with the one or more IT devices;
or
capacity data associated with the thermal buffer tank, and/or wherein the controller is configured to select the buffer tank operation based on a minimum energy consumption corresponding to the at least one cooling device.

8. The cooling system of any preceding Claim, wherein the cooling system is a two-phase cooling system, and wherein the at least one cooling device includes:
a first-phase cooling device fluidly coupled to a second-phase coolant distribution unit "CDU" by a primary fluid network (112), the CDU configured for circulating a fluid coolant through the one or more IT devices via a secondary fluid network (114),
wherein the CDU includes at least one heat exchanger (120) for transferring heat from the secondary fluid network to the primary fluid network,
and
wherein the first-phase cooling device is configured for removing the transferred heat from the primary fluid network;
and
wherein the thermal buffer tank is fluidly connected to the first-phase cooling device, and optionally wherein the first-phase cooling device is an air-cooled chiller device.

9. A method (500) for cooling an environment, the method comprising:
providing (502) at least one cooling device configured to transfer heat from one or more information technology (IT) devices by circulating a fluid coolant through the one or more IT devices;
receiving (504), via a controller of the at least one cooling device, cooling requirements associated with the one or more IT devices;
providing (506) a thermal buffer tank configured to maintain a fluid thermal buffer, the thermal buffer tank fluidly connected to the at least one cooling device and to the one or more IT devices;
receiving (508), via the controller, a weather forecast corresponding to a duration, the duration comprising a sequence of two or more segments, wherein the weather forecast includes weather data corresponding to each segment;
and
selecting (510), via the controller, a buffer tank operation corresponding to at least one first segment of the duration based on at least the weather data corresponding to the first segment, wherein the buffer tank operation includes at least one of:
charging the buffer tank with the fluid thermal buffer via the at least one cooling device;
or
transferring heat from the one or more IT devices via the fluid thermal buffer in association with the at least one cooling device.

10. The method of Claim 9, wherein the weather data includes an ambient temperature.

11. The method of Claim 10, wherein:
selecting the buffer tank operation includes determining that the ambient temperature is at most a low threshold;
and
wherein the buffer tank operation includes charging the buffer tank.

12. The method of Claim 10 or 11, wherein:
selecting the buffer tank operation includes determining that the ambient temperature is at least a high threshold;
and
wherein the buffer tank operation includes transferring heat from the one or more IT devices via the fluid thermal buffer, and/or wherein:
selecting the buffer tank operation includes determining that the ambient temperature is between a high threshold and a low threshold;
and
wherein the buffer tank operation includes taking no additional action with respect to the thermal buffer tank.

13. The method of any of Claims 9 to 12, wherein selecting, via the controller, the buffer tank operation corresponding to at least one first segment of the duration includes selecting the buffer tank operation based on at least one of:
the cooling requirements associated with the one or more IT devices; or
capacity data associated with the thermal buffer tank, and/or wherein selecting, via the controller, the buffer tank operation corresponding to at least one first segment of the duration includes selecting the buffer tank operation corresponding to a minimum energy consumption by the at least one cooling device.

14. The method of any of Claims 9 to 13, wherein providing the at least one cooling device includes:
providing a first-phase cooling device fluidly coupled to a second-phase cooling device by a primary fluid network, the second-phase cooling device configured for circulating a fluid coolant through the one or more IT devices via a secondary fluid network, and optionally wherein the first-phase cooling device is an air-cooled chiller device.

15. The method of any of Claims 9 to 14, further comprising:
signaling (512), via the controller, to the thermal buffer tank to execute the selected buffer tank operation.
